# EUROPÄISCHE PATENTSCHRIFT

(11) **EP 0 474 795 B1**
(45) Veröffentlichungstag und Bekanntmachung des Hinweises auf die Patenterteilung: **14.06.1995**
(21) Anmeldenummer: 90915436.1
(22) Anmeldetag: 31.10.1990
(51) Int. Cl.: H05K 7/20

(54) **LEITERKARTE FÜR EINE LEISTUNGS-ELEKTRONIKSCHALTUNG**
PRINTED CIRCUIT BOARD FOR A POWER ELECTRONIC CIRCUIT
CARTE DE CIRCUITS IMPRIMES POUR CIRCUIT ELECTRONIQUE DE PUISSANCE

(30) Priorität: 30.03.1990 DE 4010193
(43) Veröffentlichungstag der Anmeldung: 18.03.1992
(73) Patentinhaber: Rheinmetall Industrie GmbH, 40880 Ratingen (DE)
(72) Erfinder: LAMERS, Johannes, D-4040 Neuss 22 (DE)
(86) Internationale Anmeldenummer: EP9001826
(87) Internationale Veröffentlichungsnummer: WO9115938

(56) Entgegenhaltungen:
- EP-A- 0 014 249
- EP-A- 0 197 817

## Beschreibung

Die Erfindung betrifft eine einseitig bestückte Leiterkarte für eine Leistungs-Elektronikschaltung in SMD-Ausführung (Surface Mounted Devices).

Es ist bekannt, zur Abfuhr der entstehenden Wärme bei Leistungs-Elektronikschaltungen entweder die gesamte Leiterkarte oder alle stark wärmeentwickelnden Bauteile der Schaltung auf Kühlkörper zu montieren. Bei hoher Leistungsaufnahme, beispielsweise 250 W und mehr, müssen diese Leiterkarten und/oder die Kühlkörper zusätzlich mittels eines Ventilators gekühlt werden. Insgesamt wird dadurch das erforderliche Bauvolumen für eine solche Leistungs-Elektronikschaltung in unerwünschter Weise vergrößert.

Es ist ferner aus der EP-A-0 014 249 eine Leiterkarte bekannt, bei der der Kühlkörper aus einem Kunststoffbehälter besteht, der im wesentlichen durch miteinander verschweißte Folien zusammengesetzt ist. Dieser Kühlkörper weist ferner Ein- und Auslaufstutzen auf, durch die die Kühlflüssigkeit in den Kühlkörper bzw. wieder aus diesem heraus gelangen kann.

Der Erfindung liegt die Aufgabe zugrunde, eine Leiterkarte für eine Leistungs-Elektronikschaltung in SMD-Ausführung zu schaffen, die unter Vermeidung der oben angeführten Nachteile trotz kleiner Bauweise eine gute Kühlung selbst bei hoher Leistungsaufnahme gewährleistet.

Diese Aufgabe wird erfindungsgemäß von einer Leiterkarte für eine Leistungs-Elektronikschaltung in SMD-Ausführung mit den Merkmalen des kennzeichnenden Teils des Patentanspruchs 1 gelöst.

Durch die erfindungsgemäße Integration der Leiterkarte selbst in ein von einem flüssigen Kühlmittel durchströmten Gehäuse ergibt sich der große Vorteil, eine einfache, gegebenenfalls sogar drucklose Flüssigkeitskühlung der Leiterkarte zu ermöglichen. Insbesondere wenn die erfindungsgemäße Leiterkarte in solchen Maschinen Verwendung findet, -die über einen vorhandenen Flüssigkeits-Kreislauf verfügen, beispielsweise Waschmaschinen (Wasserzufuhr), Ultraschall-Waschanlagen und Automobile (Kühler-Kreislauf), läßt sich die erfindungsgemäße Leiterkarte als Deckel eines sowieso schon vorhandenen Gehäuses innerhalb des Flüssigkeits-Kreislaufes sehr einfach integrieren. Der zusätzliche Platzbedarf, wenn überhaupt, für die erfindungsgemäße Leiterkarte ist in diesen Fällen sehr gering, besonders im Vergleich mit den bisher bekannten erforderlichen Kühlkörpers und/oder Ventilatoren.

In vorteilhafter Ausgestaltung der Erfindung ist weiterhin vorgesehen, die erfindungsgemäße Leiterkarte als an sich bekannte Hybrid-Karte auszuführen, so daß eine hohe mechanische Festigkeit der Leiterkarte erzielbar ist und sie auf diese Weise als Teil eines von einem Kühlmittel durchströmten Gehäuses an die für das Gehäuse geltenden mechanischen Festigkeiten angepaßt werden kann.

Eine solche erfindungsgemäße Leiterkarte in Hybrid-Ausführung ist mit bekannten Herstellungsverfahren an sich in nahezu allen denkbaren Formen herstellbar und kann in Form eines Deckels oder in ähnlicher Verwendung bei nahezu beliebigen Gehäuseformen, beispielsweise rechteckigen, kastenförmigen, rohrförmigen oder dreieckförmigen Gehäusen oder daraus abgeleiteten Formen, verwendet werden.

In besonderer Ausführungsform der Erfindung ist weiterhin vorgesehen, auf der erfindungsgemäßen Leiterkarte neben der Leistungs-Elektronikschaltung eine weitere Schaltung zur Kontrolle und Erfassung ihrer Temperatur und zur Steuerung bzw. Regulierung des Kühlmittelstromes vorgesehen. Damit ist auf einfache Weise in Abhängigkeit der aufgenommenen Leistung und der damit bedingten Wärmeabgabe eine Regulierung bzw. Anpassung an die geforderte Wärmeabfuhr möglich.

Weitere vorteilhafte Ausgestaltungen der Erfindung gehen aus den Unteransprüchen hervor.

Die Erfindung wird nachfolgend unter Zuhilfenahme einer Zeichnung ausführlich beschrieben und erläutert; dabei zeigen:
- Figur 1:: Ein Ausführungsbeispiel einer erfindungsgemäßen Leiterkarte;
- Figur 2:: ein rechteckiges, kastenförmiges Gehäuse mit einer Leiterkarte gemäß Figur 1 als Deckel;
- Figur 3:: ein Schnitt durch das Gehäuse gemäß Figur 2 etwa in Höhe der dort mit III-III bezeichneten Markierung;
- Figur 4:: ein Gehäuse mit einem dreieckförmigen Querschnitt und mit einer Leiterkarte gemäß Figur 1 als Deckel und
- Figur 5:: ein rohrförmiges Gehäuse mit einer Leiterkarte gemäß Figur 1.

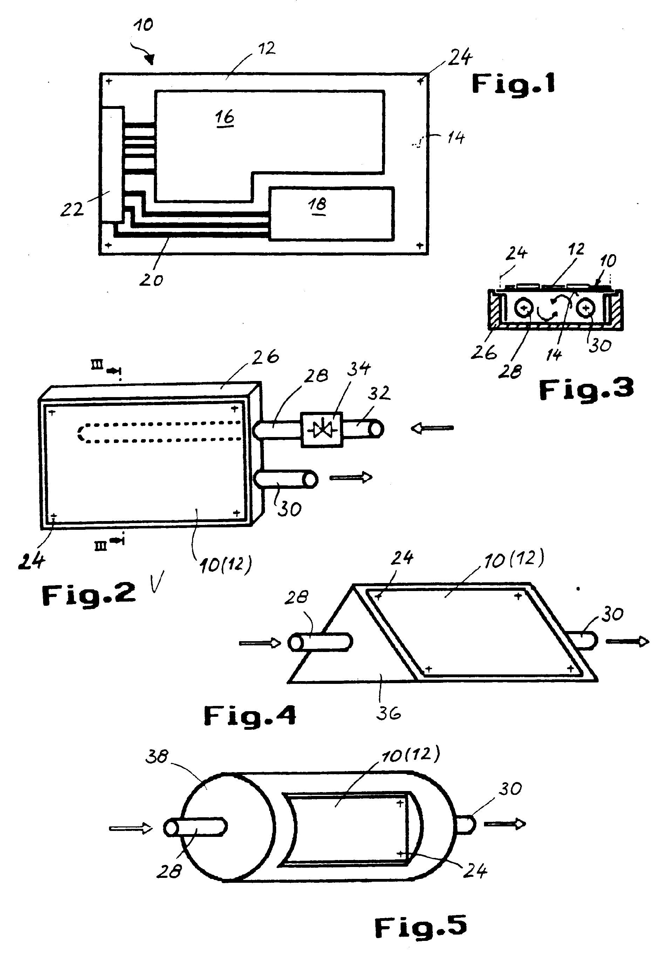

In Figur 1 ist ein Ausführungsbeispiel einer erfindungsgemäßen einseitig bestückten Leiterkarte 10 dargestellt, die eine Leistungs-Elektronikschaltung 16 und eine weitere Schaltung 18 zur Erfassung und Kontrolle der Leiterkarten-Temperatur (bzw. zur Erfassung der Temperatur eines Kühlmittels) und zur Steuerung von nachgeschalteten Stellgliedern enthält.

Solche Schaltungen 16, 18 sind in ihrer elektronischen Auslegung dem Fachmann geläufig und in an sich bekannter Weise als gedruckte Schaltungen mit SMD-Bestückung ausgeführt. Die Schaltungen 16, 18 sind daher der Einfachheit halber nur schematisch dargestellt.

Aufgrund der SMD-Bestückung und Ausführung der Leiterkarte 10 ergibt sich daher eine Bestückungsseite 12 und eine unbestückte Seite 14 der Leiterkarte 10, wobei die letztere direkt vom Kühlmittelstrom angeströmt werden kann.

Vorzugsweise ist die Leiterkarte 10 bei geforderter höherer Festigkeit als Hybrid-Karte gefertigt, wobei je nach Anwendungsfall die Leiterkarte 10 aus einem metallhaltigem Werkstoff, beispielsweise einem Stahlsubstrat, oder aus keramischem Werkstoff besteht.

Zur lösbaren Befestigung der Leiterkarte 10 sind bei dem hier dargestellten Ausführungsbeispiel Schrauben vorgesehen, deren Position auf der Leiterkarte 10 durch die mit 24 bezeichneten Schraubenmittelpunkte angedeutet sind. Selbstverständlich sind ohne Einschränkung der Erfindung andere Befestigungsarten der Leiterkarte 10 denkbar, also auch unlösbare Befestigungsarten, wie z. B. Kleben.

Figur 2 zeigt ein von einem flüssigen Kühlmittel durchströmtes rechteckiges, kastenförmiges Gehäuse 26, bei dem die erfindungsgemäße Leiterkarte 10 aus Figur 1 als Deckel einer Längsseite oder eines Teils davon verwendet wird. Das hier nicht näher dargestellte flüssige Kühlmittel, beispielsweise Wasser oder Öl, tritt durch einen mit 28 bezeichnet Einlaufstutzen in das Gehäuse 26 ein, zirkuliert innerhalb des Gehäuses 26 und tritt durch ein mit 30 bezeichneten Auslaufstutzen aus dem Gehäuse 26 aus. Zur besseren Verwirbelung des Kühlmittels innerhalb des Gehäuses 26 ist der Einlaufstutzen 28 vorzugsweise, wie in Figur 2 dargestellt, als längeres, in das Gehäuse 26 ragendes Rohr ausgeführt. Die Leiterkarte 10, von der in Figur 2 wiederum nur die Bestückungsseite 12 zu sehen ist, ist mit dem Gehäuse 26 lösbar, beispielsweise durch Schrauben 24 verbunden. Die unbestückte Seite 14 der Leiterkarte wird direkt vom Kühlmittel angeströmt. Im Gehäuse 26 selbst können selbstverständlich, ohne Einschränkung des Erfindungsgedankens, zur Verbesserung der Verwirbelung des Kühlmittels auch Prallstege oder Leitzonen zur Umlenkung des Kühlmittels vorgesehen werden.

Zur Einstellung einer gewünschten Durchflußmenge von Kühlmittel durch das kastenförmige Gehäuse 26 ist in einer mit 32 bezeichneten Zulauf-Leitung für das Kühlmittel ein Durchflußmengenregler 34, vorzugsweise ein elektrisch verstellbarer Durchflußmengenregler, vorgesehen. Dieser Durchflußmengenregler 34 ist von der auf der Leiterkarte 10 vorgesehenen Temperaturerfassungs- und Kontroll-Schaltung 18 (siehe dazu Figur 1) durch hier nicht näher dargestellte Anschlüsse elektrisch ansteuerbar.

Derartige elektrisch steuerbare Durchflußmengenregler 34 sind dem Fachmann an sich geläufig und nicht Gegenstand der Erfindung. Ohne Einschränkung der Erfindung ist es auch denkbar, die eigentliche Temperaturerfassung und Kontrolle über einen entsprechend ausgelegten Temperaturfühler innerhalb des Gehäuses 26 auszuführen und die Temperaturerfassungs- und Kontroll-Schaltung 18 (siehe Figur 1) auf reine Vergleichs- und Steuerfunktion zu beschränken.

Figur 3 zeigt einen Schnitt durch das kastenförmige Gehäuse 26 der Figur 2 etwa in Höhe der in Figur 2 durch III-III veranschaulichten Markierung. Zur Verdeutlichung der Anbringung und Funktion der erfindungsgemäßen Leiterkarte 10 dienen die dargestellten Einzelteile in ihrer Zuordnung und unter Beibehaltung der schon oben erwähnten Bezugszeichen. Deutlich zu sehen ist in Figur 3 die eigentliche Leiterkarte 10 und ihre unbestückte Seite 14, die von dem durch den Einlaufstutzen 28 in das Gehäuse 26 eingetretenen flüssigen Kühlmittel infolge Verwirbelung angeströmt wird.

Falls die Leiterkarte 10 aus korrosionsempfindlichem metallhaltigem Werkstoff gefertigt ist, ist ihre unbestückte Seite 14 vorzugsweise mit einer dünnen Korrosionsschutz-Beschichtung versehen.

Die Befestigung der Leiterkarte 10 im oder am Gehäuse 26 geschieht, wie schon erwähnt, durch Schrauben 24, so daß ein Auswechseln der Leiterkarte 10 auf einfache Weise möglich ist. Selbstverständlich ist zwischen der Leiterkarte 10 und einem umlaufenden Kragen, hier nicht näher bezeichnet, des Gehäuses 26, auf dem die Leiterkarte 10 aufliegt, eine an sich bekannte Dichtung, beispielsweise ein umlaufender O-Ring in entsprechender Nut, vorgesehen.

In Figur 4 ist ein weiteres hohles Gehäuse 36 dargestellt, das einen im wesentlichen dreieckförmigen Querschnitt aufweist und bei dem entsprechend dem in Figur 2 dargestellten kastenförmigen Gehäuse 26 die erfindungsgemäße Leiterkarte 10 als Deckel einer Längsseite verwendet wird. Die Leiterkarte 10, von der auch hier nur die bestückte Seite 12 zu sehen ist, ist wiederum der Einfachheit halber lösbar durch Schrauben 24 mit dem Gehäuse 36 verbunden. In weiterer Ausgestaltung der Erfindung ist bei dem in Figur 4 dargestellten Gehäuse in der einen Stirnseite der Einlaufstutzen 28 für das flüssige Kühlmittel und in der gegenüberliegenden Stirnseite der Auslaufstutzen 30 angeordnet. Vorzugsweise sind der Einlaufstutzen 28 und der Auslaufstutzen 30 nicht axial fluchtend zueinander angeordnet, so daß beide Stutzen 28, 30 jeweils - wie in Figur 2 am Beispiel des Einlaufstutzens 28 dargestellt - als verlängerte Rohre in den Innenraum des Gehäuses 36 auslaufen können. Diese Maßnahme dient wie bei Figur 2 der besseren Verwirbelung des flüssigen Kühlmittels innerhalb des Gehäuses 36.

Darüber hinaus gilt das für das Gehäuse 26 (Figuren 2 und 3) oben Gesagte entsprechend.

Zur weiteren Veranschaulichung der vielfältigen Einsatzmöglichkeiten der erfindungsgemäßen Leiterkarte 10 ist in Figur 5 ein im wesentlichen jeweils endseitig verschlossenes rohrförmiges Gehäuse 38 mit Einlaufstutzen 28 und Auslaufstutzen 30 dargestellt, bei dem die Leiterkarte 10 eine entsprechend gestaltete Ausnehmung, hier nicht näher bezeichnet, in der Wandung des Gehäuses 38 bedeckt und abdichtet. Auch für dieses Ausführungsbeispiel der Figur 5 ist das oben zu den Figurenbeschreibungen für die Figuren 1 bis 4 Gesagte entsprechend anwendbar.

In praktischen Versuchen hat sich bereits gezeigt, daß die erfindungsgemäße Leiterkarte als Teil eines Gehäuses auf einfache Weise bei beliebiger Gehäuseform in einen vorhandenen Kreislauf einer als Kühlmittel verwendbaren Flüssigkeit integrierbar ist. Die Erfindung zeichnet sich durch kostengünstige Herstellung, kleine Bauweise, geringes Gewicht und einfache Montage aus. Die Erfindung kann darüber hinaus mit kostengünstigen handelsüblichen Gehäusen verwendet werden, die sich auf einfache Weise in vorhandene Kühl mittel-Kreisläufe integrieren lassen oder sie kann bei besonderer Formgebung der Leiterplatte Deckel oder dementsprechende Teile von im Kreislauf vorhandenen Gehäusen oder Teilen davon ersetzen.

### Bezugszeichen-Liste

- 10: Leiterkarte
- 12: Bestückungsseite von (10)
- 14: unbestückte Seite von (10)
- 16: Leistungsschaltung
- 18: Temperatur Erfassungs- und Kontroll-/Steuerschaltung
- 20: Leiterbahnen
- 22: Steckverbinder
- 24: Schrauben
- 26: rechteckiges, kastenförmiges Gehäuse
- 28: Einlaufstutzen für Kühlmittel
- 30: Auslaufstutzen für Kühlmittel
- 32: Leitung
- 34: Durchflußmengenregler
- 36: dreieckförmiges Gehäuse
- 38: rohrförmiges Gehäuse

## Patentansprüche

1. Einseitig bestückte Leiterkarte (10) für eine Leistungs-Elektronikschaltung (16) in SMD-Ausführung, wobei die Leiterkarte (10) an einem mit einem flüssigen Kühlmittel durchströmten Gehäuse (26;36;38) angeordnet ist, welches mit Ein- bzw. Auslaufstutzen (28,30) für die Zufuhr und den Ablauf des Kühlmittels versehen ist, **dadurch gekennzeichnet,** daß die unbestückte Seite (14) der Leiterkarte (10) die Innenwand oder Teil der Innenwand des von dem flüssigen Kühlmittel durchströmten Gehäuses (26;36;38) bildet.

2. Leiterkarte (10) gemäß Anspruch 1,
**dadurch gekennzeichnet,** daß
sie aus einem metallhaltigen Werkstoff besteht und mit einer Isolationsschicht zwischen Leiterbahnen (20) und Leiterkarte (10) versehen ist.

3. Leiterkarte (10) gemäß Anspruch 2,
**dadurch gekennzeichnet,** daß
die Leiterkarte (10) aus einem Stahl-Substrat gefertigt ist.

4. Leiterkarte (10) gemäß Anspruch 1,
**dadurch gekennzeichnet,** daß
sie aus einem keramischen Werkstoff gefertigt ist.

5. Leiterkarte (10) nach einem der vorhergehenden Ansprüche 1 bis 4,
**dadurch gekennzeichnet,** daß
die Leiterkarte (10) als Deckel eines im wesentlichen rechteckigen, kastenförmigen Gehäuses (26) vorgesehen ist.

6. Leiterkarte (10) nach einem der vorhergehenden Ansprüche 1 bis 4,
**dadurch gekennzeichnet,** daß
die Leiterkarte (10) als Deckel eines Gehäuses (36) mit einem im wesentlichen dreieckförmigen Querschnitt vorgesehen ist.

7. Leiterkarte (10) nach einem der vorhergehenden Ansprüche 1 bis 4,
**dadurch gekennzeichnet,** daß
die Leiterkarte (10) als Deckel eines Gehäuses (38) mit im wesentlichen rohrförmigen Querschnitt vorgesehen ist.

8. Leiterkarte (10) nach einem der Ansprüche 2, 3, 4, 5, 6, 7,
**dadurch gekennzeichnet,** daß
die unbestückte Seite (14) der Leiterkarte (10) mit einer Korrosionsschutz-Beschichtung versehen ist.

9. Leiterkarte (10) nach einem der vorhergehenden Ansprüche 1 bis 9,
**dadurch gekennzeichnet,** daß
sie neben der Leistungs-Elektronikschaltung (16) eine weitere Schaltung (18) zur Kontrolle und Erfassung ihrer Temperatur und zur Steuerung von Mitteln (34) zur Regulierung des Kühlmittelstromes durch das Gehäuse aufweist.

## Claims

1. Single-sided printed circuit board (10) for an electronic power circuit (16), of SMD construction, the circuit board (10) being mounted on a housing (26;36;38) through which a liquid coolant flows and which is provided with inlet and outlet connections (28,30) for the supply and discharge of the coolant, characterised by the fact that the unprinted side (14) of the circuit board (10) forms the inner wall or part of the inner wall of the housing (26;36;38) through which the liquid coolant flows.

2. Circuit board (10) in accordance with Claim 1, characterised by the fact that it comprises a metal containing material and is provided with an insulating layer between the conductor strips (20) and the circuit board (10).

3. Circuit board (10) in accordance with Claim 2, characterised by the fact that the circuit board (10) has a steel substrate.

4. Circuit board (10) in accordance with Claim 1, characterised by the fact that it is made of a ceramic material.

5. Circuit board (10) in accordance with any one of the preceding Claims 1 to 4, characterised by the fact that the circuit board (10) is provided as a cover for a substantially rectangular box-shaped housing (26).

6. Circuit board (10) in accordance with any one of the preceding Claims 1 to 4, characterised by the fact that the circuit board (10) is provided as a cover for a housing (36) with a substantially triangular cross section.

7. Circuit board (10) in accordance with any one of the preceding Claims 1 to 4, characterised by the fact that the circuit board (10) is provided as a cover for a housing (38) with a substantially tubular cross section.

8. Circuit board (10) in accordance with any one of Claims 2, 3, 4, 5,6,7, characterised by the fact that the unprinted side (14) of the circuit board (10) is provided with an anti-corrosion coating.

9. Circuit board (10) in accordance with any one of the preceding Claims 1 to 8, characterised by the fact that in addition to the electronic power circuit (16) a further circuit (18) is provided for monitoring and detecting the temperature and for the control of a means (34) for regulating the flow of coolant through the housing.

## Revendications

1. Carte de circuits imprimés (10), équipée sur une face, pour un circuit électronique de puissance (16) en réalisation SMD, la carte (10) étant placée sur un boîtier (26 ; 36 ; 38), traversé par un réfrigérant liquide, le boîtier étant pourvu de tubulures d'entrée ou de sortie (28, 30) pour l'arrivée et le départ du réfrigérant, caractérisée en ce que la face (14) non équipée de la carte (10) forme la paroi intérieure ou la partie de la paroi intérieure du boîtier (26 ; 36 ; 38), traversée par le réfrigérant liquide.

2. Carte de circuits imprimés (10) selon la revendication 1, caractérisée en ce qu'elle est réalisée en un matériau métallique et est pourvue d'une couche d'isolation entre des pistes conductrices (20) et la carte (10).

3. Carte de circuits imprimés (10) selon la revendication 2, caractérisée en ce que la carte (10) est réalisée en un substrat d'acier.

4. Carte de circuits imprimés (10) selon la revendication 1, caractérisée en ce qu'elle est réalisée en un matériau céramique.

5. Carte de circuits imprimés (10) selon l'une des revendications 1 à 4 précédentes, caractérisée en ce que la carte (10) est prévue comme couvercle d'un boîtier (6) en forme de boîte, sensiblement rectangulaire.

6. Carte de circuits imprimés (10) selon l'une des revendications 1 à 4 précédentes, caractérisée en ce que la carte (10) est prévue comme couvercle d'un boîtier (36) de section transversale sensiblement triangulaire.

7. Carte de circuits imprimés (10) selon l'une des revendications 1 à 4 précédentes, caractérisée en ce que la carte (10) est prévue comme couvercle d'un boîtier (38) de section transversale sensiblement tubulaire.

8. Carte de circuits imprimés (10) selon l'une des revendications 2, 3, 4, 5, 6, 7, caractérisée en ce que la face (14) non équipée de la carte (10) est pourvue d'un revêtement de protection contre la corrosion.

9. Carte de circuits imprimés (10) selon l'une des revendications 1 à 9 précédentes, caractérisée en ce qu'elle comporte, outre le circuit électronique de puissance (16), un autre circuit (18) pour le contrôle et l'enregistrement de sa température et pour la commande de moyens (34) destinés à réguler le courant de réfrigérant à travers la boîtier.
